# FASCICULE DE BREVET EUROPEEN

(11) **EP 0 490 710 B1**
(45) Date de publication et mention de la délivrance du brevet: **15.03.1995**
(21) Numéro de dépôt: 91402799.0
(22) Date de dépôt: 22.10.1991
(51) Int. Cl.: G01D 5/20, G01R 11/24

(54) **Procédé et dispositif pour la détection d'un déplacement**
Verfahren und Vorrichtung zur Detektion einer Verschiebung
Method and device for the detection of a displacement

(30) Priorité: 07.12.1990 FR 9015333
(43) Date de publication de la demande: 17.06.1992
(73) Titulaire: SCHLUMBERGER INDUSTRIES, F-92120 Montrouge (FR)
(72) Inventeur: Niven, Rex, F-91440 Bures S/Yvette (FR); Siuta, Marcel, F-86170 Neuville de Poitou (FR)
(74) Mandataire: Bentz, Jean-Paul

(56) Documents cités:
- DE-A- 1 908 011
- GB-A- 589 442

## Description

La présente invention concerne de façon générale la détection du déplacement même temporaire, à partir d'une position relative initiale, d'un premier élément par rapport à un second.

L'application la plus typique de l'invention est un peu comparable à celle des dispositifs de plombage, utilisés pour vérifier l'intégrité d'un produit, par exemple d'un appareil de mesure tel qu'un compteur d'électricité, qui est confié à un utilisateur éventuellement susceptible de chercher à le démonter pour le falsifier.

Dans ces techniques connues, les deux éléments dont le déplacement relatif est surveillé sont généralement une vis et un support, et ces éléments sont reliés par un plomb d'authentification qui est détruit par le démontage de la vis.

Ainsi, la vérification visuelle de l'état du plomb permet de déceler a posteriori le déplacement, même temporaire, de cette vis par rapport à son support et de présumer par conséquent le démontage de tout élément que cette vis sert à maintenir.

Si cette technique a donné, et continue de donner, toute satisfaction dans un grand nombre d'applications, elle souffre en revanche de ne permettre qu'une détection a posteriori, c'est-à-dire susceptible de n'être éventuellement effectuée que très longtemps après le déplacement surveillé, et nécessitant de surcroît l'intervention d'un opérateur humain.

Dans ce contexte, le but de la présente invention est de fournir des moyens simples pour effectuer une détection rapide et automatique du déplacement de deux éléments l'un par rapport à l'autre.

A cette fin, le dispositif de l'invention est essentiellement caractérisé en ce qu'il comprend :
- un circuit magnétique à rémanence comprenant au moins deux parties dont l'une a une position dépendante de celle du premier élément et dont l'autre a une position dépendante de celle du second élément, ce circuit étant de cette façon fermé pour ladite position initiale desdits éléments, et ouvert pour toute autre position de ces derniers,
- des moyens d'excitation du circuit magnétique, capables de placer le circuit magnétique, lorsqu'il est fermé, dans un état magnétique déterminé,
- des moyens de commande reliés aux moyens d'excitation, pour commander le fonctionnement de ces derniers, et
- des moyens de détection, propres à produire un signal de détection de déplacement en réponse à une évolution particulière de l'état du circuit magnétique sous l'effet des moyens d'excitation, ces moyens de détection comprenant avantageusement un circuit de détection monopolaire.

De son côté, le procédé de l'invention est essentiellement caractérisé en ce qu'il comprend les opérations consistant à :
- provoquer l'ouverture d'un circuit magnétique à rémanence, initialement magnétisé, en cas de déplacement desdits premier et second éléments par rapport à leur position relative initiale,
- exciter ce circuit magnétique de manière à tenter de le placer successivement dans un état magnétisé, dans un état démagnétisé, puis à nouveau dans un état magnétisé,
- détecter les changements d'état du circuit magnétique au moins à chaque tentative de magnétisation de ce dernier, et
- produire un signal de détection de déplacement dans le cas où un changement d'état déterminé du circuit magnétique n'a pas été détecté à la suite de la démagnétisation de ce circuit, ou a en outre été détecté à un autre instant.

En outre les opérations consistant à exciter le circuit magnétique, et à détecter les changements d'état de ce dernier peuvent être périodiquement réitérées pour effectuer une surveillance continue de l'absence de tout déplacement relatif des premier et second éléments.

D'autres caractéristiques et avantages de l'invention ressortiront clairement de la description qui en est faite ci-après, à titre indicatif et nullement limitatif, en référence au dessin annexé, sur lequel:
- La figure 1 est un schéma général d'un dispositif conforme à l'invention;
- La figure 2, composée des figures 2a à 2e, est une représentation, en fonction du temps, de signaux électriques observables dans la mise en oeuvre du dispositif de la figure 1; et
- La figure 3 est un organigramme représentant la séquence d'opérations effectuées dans le procédé de l'invention.

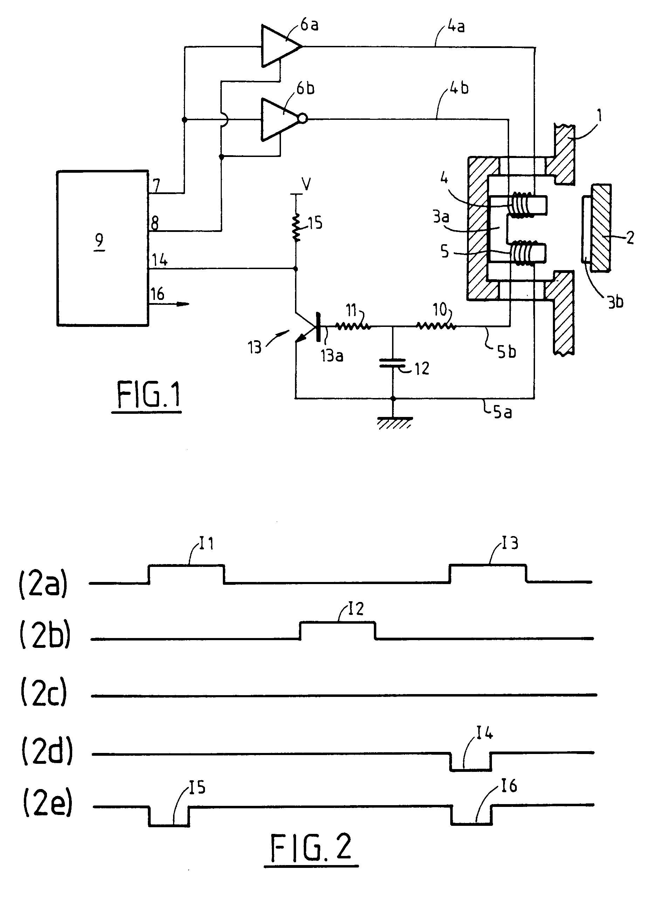

Le dispositif de l'invention permet de détecter le déplacement temporaire, à partir d'une position initiale relative, de deux éléments 1 et 2 représentés schématiquement et en coupe sur la figure 1.

Par exemple, l'élément 1 est constitué par le boîtier d'un compteur d'énergie électrique, représenté de façon seulement partielle pour des raisons de clarté, et l'élément 2 est un cache-bornes destiné, en service normal, à rester fixé au boîtier, l'invention permettant donc de détecter l'ouverture du cache-bornes.

Le dispositif comprend tout d'abord un circuit magnétique composé de deux parties 3a et 3b.

Par exemple, la première partie 3a de ce circuit adopte la forme d'un noyau en "U", et la seconde partie 3b celle d'une palette réalisée en un matériau à rémanence magnétique qui, lorsque les éléments 1 et 2 sont dans leur position initiale et normale, forme avec le noyau 3a un circuit magnétique fermé.

La première partie 3a est par exemple rendue solidaire, par tout moyen approprié, du boîtier 1, tandis que la seconde 3b est fixée au cache-bornes 2.

Selon une variante possible, la palette 3b peut néanmoins rester solidaire du boîtier 1, pourvu que sa position par rapport au noyau 3a reste dépendante de la position du cache-bornes 2 par rapport au boîtier 1, et que le circuit magnétique soit d'une part fermé pour la position relative initiale des éléments 1 et 2 et d'autre part ouvert dès que ces éléments 1 et 2 sont déplacés de leur position relative initiale.

Le noyau 3a est doté d'une bobine d'excitation 4 et d'une bobine de détection 5.

Une des bornes, 4a, de la bobine d'excitation 4 est reliée à la sortie d'un amplificateur 6a dont les entrées d'alimentation et de commande sont elles-mêmes reliées à des bornes respectives 7 et 8 d'un microprocesseur 9.

L'autre borne, 4b, de la bobine 4 est reliée à la sortie d'un amplificateur 6b à sortie inversée, dont les entrées d'alimentation et de commande sont respectivement reliées aux mêmes bornes 7 et 8 du microprocesseur 9 que les entrées de l'amplificateur 6a.

Par ailleurs, une des bornes, 5a, de la bobine de détection 5 est reliée à la masse, tandis que l'autre borne, 5b, de cette même bobine est reliée à l'entrée d'un filtre passe-bas composé par exemple de deux résistances en série 10 et 11, dont la borne commune est reliée à la masse par l'intermédiaire d'une capacité 12.

La sortie 13a du filtre passe-bas 10, 11, 12 est d'une part reliée à la masse à travers la jonction base - émetteur d'un transistor NPN 13, et d'autre part reliée, à travers la jonction base - collecteur de ce même transistor, à une entrée 14 du microprocesseur 9, elle-même connectée à une source de potentiel positif constant V par l'intermédiaire d'une résistance 15.

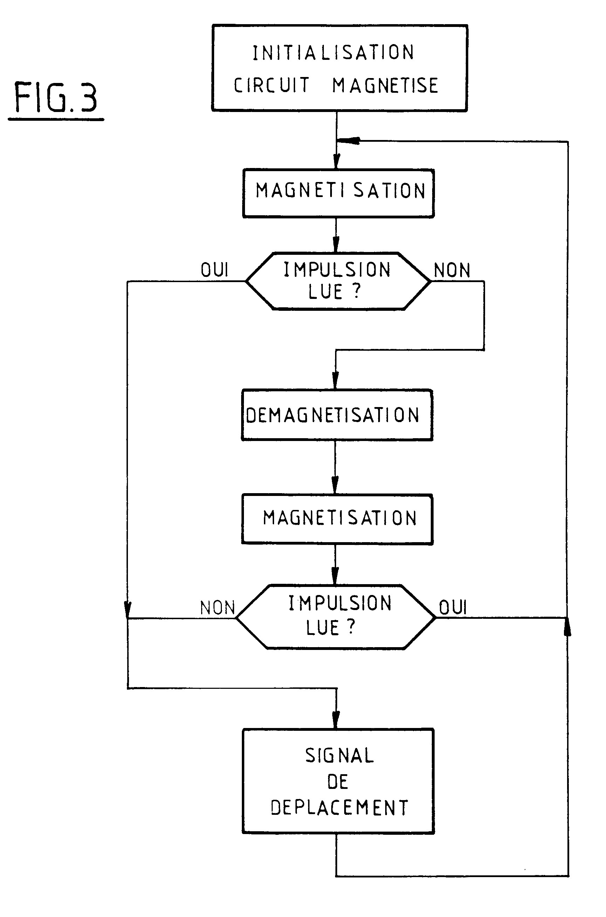

La structure précédemment décrite permet notamment, par une programmation appropriée du microprocesseur 9, explicitée en référence aux figures 2 et 3, de placer le circuit magnétique 3a, 3b dans l'un ou l'autre de deux états magnétiques bien distincts, pourvu cependant que ce circuit soit fermé, c'est-à-dire que les éléments 1 et 2 se trouvent dans leur position initiale et normale.

La figure 2a représente l'état électrique de la borne d'alimentation 7 des amplificateurs 6a et 6b, et la figure 2b celui de la borne de commande 8 de ces amplificateurs.

Lorsque, comme c'est le cas pendant le temps des impulsions I1 et I3, le microprocesseur 9 met la borne d'alimentation 7 dans un état électrique "haut", et la borne de commande 8 dans un état électrique "bas", la bobine d'excitation 4 est parcourue par un courant circulant dans un premier sens.

Le circuit magnétique 3a, 3b, s'il est fermé au moment de son excitation, est alors placé dans un état magnétisé, qu'il peut conserver indéfiniment sans apport d'énergie aussi longtemps qu'il reste fermé, dans la mesure où la palette est constituée d'un matériau à rémanence magnétique.

Lorsqu'en revanche, comme c'est le cas pendant le temps de l'impulsion I2, le microprocesseur 9 met la borne d'alimentation 7 dans un état électrique "bas", et la borne de commande 8 dans un état électrique "haut", la bobine d'excitation 4 est alors parcourue par un courant circulant en sens inverse du premier, et le circuit magnétique 3a, 3b se replace dans un état démagnétisé semblable à celui dans lequel il se trouve lorsqu'il a été ouvert puis refermé, et sans que la bobine 4 ait été excitée depuis.

Les impulsions I1, I2, I3 ont par exemple chacune une durée de 10 millisecondes.

La figure 2c représente l'état électrique de la borne d'entrée 14 du microprocesseur 9 dans le cas où le circuit magnétique 3a, 3b a été ouvert et se trouve toujours dans cette position au moment où sont produites les impulsions I1, I2, et I3.

Dans un tel cas, non seulement le circuit magnétique est démagnétisé, mais il est en outre incapable de changer d'état, de sorte que la bobine de détection 5 ne reçoit aucun signal, même pendant les instants I1 et I3 où la bobine d'excitation est alimentée pour magnétiser le circuit.

Le transistor 13 ne recevant lui-même aucun signal, il reste bloqué et la borne d'entrée 14 reste au potentiel V.

La figure 2d représente l'état électrique de cette même borne 14 dans le cas où le circuit magnétique 3a, 3b est fermé et se trouve dans un état magnétisé avant que l'impulsion I1 ne soit produite.

Dans un tel cas, cette impulsion I1 laisse le circuit magnétique dans son état antérieur, mais l'impulsion I2 a pour effet de le démagnétiser, et l'impulsion I3 celui de le magnétiser à nouveau.

L'impulsion I1, n'étant responsable d'aucun changement d'état, ne produit aucune impulsion dans la bobine de détection 5.

L'impulsion I2, responsable d'une démagnétisation du circuit 3a, 3b, fait apparaître une impulsion négative dans la bobine de détection 5. Cependant la polarité du circuit monopolaire que constituent les composants 10 à 13 est telle que cette impulsion est sans effet sur l'état du transistor 13. Ce dernier reste donc bloqué et l'entrée 14 du microprocesseur 9 ne change pas d'état.

En revanche, l'impulsion I3, responsable d'une nouvelle magnétisation du circuit 3a, 3b, fait apparaître une impulsion positive dans la bobine de détection 5. Cette impulsion, filtrée par le filtre passe-bas 10, 11, 12, rend le transistor 13 passant pendant un certain temps et produit sur l'entrée 14 du microprocesseur 9 une impulsion I4 correspondante.

Enfin, la figure 2e représente l'état électrique de la borne 14 dans le cas où le circuit magnétique 3a, 3b est fermé mais se trouve dans un état démagnétisé avant que l'impulsion I1 ne soit produite.

Dans un tel cas, l'impulsion I1 a sur le circuit magnétique 3a, 3b le même effet qu'avait l'impulsion I3 dans le cas précédemment exposé, de sorte que l'entrée 14 du microprocesseur 9 reçoit une impulsion I5 coïncidant avec l'impulsion I1 et une impulsion I6 coïncidant avec l'impulsion I3.

Comme le montre la description précédente, et en supposant le circuit magnétique initialement fermé et magnétisé, la détection d'un signal tel que 2c indique que les éléments 1 et 2 se trouvent dans une position déplacée par rapport à leur position relative initiale, la détection d'un signal tel que 2d indique que les éléments 1 et 2 se trouvent toujours dans leur position relative initiale et n'en ont pas été déplacés, et la détection d'un signal tel que 2e indique que les éléments 1 et 2 se trouvent bien dans leur position relative initiale mais en ont été temporairement déplacés.

Pour exploiter au mieux ces propriétés du dispositif de la figure 1, le procédé de l'invention comprend une séquence d'opérations, représentée à la figure 3, et qui peut être renouvelée de façon indéfinie, par exemple à des intervalles de l'ordre d'une seconde, pour assurer une surveillance continue de tout éventuel déplacement relatif des éléments 1 et 2.

Après application de l'impulsion I1, correspondant à la première magnétisation ou tentative de magnétisation du circuit 3a, 3b, et en cas de détection d'une impulsion I5, le microprocesseur 9 produit, par exemple sur sa sortie 16, un signal indiquant le déplacement, toujours observable à l'instant considéré, des éléments 1 et 2, et se reboucle au début de son programme.

En l'absence d'impulsion I5, il applique l'impulsion I2 de tentative de démagnétisation, puis l'impulsion I3 de tentative de remagnétisation.

Après application de cette dernière, et en cas de défaut de détection d'une impulsion I4, le microprocesseur 9 produit, par exemple sur sa sortie 16, un signal indiquant un déplacement, ancien et corrigé à l'instant considéré, des éléments 1 et 2.

Il se reboucle ensuite au début de son programme.

Grâce aux caractéristiques décrites, le procédé et le dispositif de l'invention permettent donc de déceler de façon automatique, même a posteriori, un déplacement, temporaire ou non, des éléments 1 et 2, et ceci même si le dispositif a été temporairement privé d'énergie électrique, que ce soit avant, pendant ou après le déplacement des éléments 1 et 2.

## Revendications

1. Procédé pour détecter le déplacement temporaire, à partir d'une position initiale relative, d'un premier élément (1) par rapport à un second (2), caractérisé en ce qu'il comprend les opérations consistant à :
- provoquer l'ouverture d'un circuit magnétique à rémanence (3a, 3b), initialement magnétisé, en cas de déplacement desdits premier et second éléments par rapport à leur position relative initiale,
- exciter ce circuit magnétique de manière à tenter de le placer successivement dans un état magnétisé, dans un état démagnétisé, puis à nouveau dans un état magnétisé,
- détecter les changements d'état du circuit magnétique au moins à chaque tentative de magnétisation de ce dernier, et
- produire un signal de détection de déplacement dans le cas où un changement d'état déterminé du circuit magnétique n'a pas été détecté à la suite de la démagnétisation de ce circuit, ou a en outre été détecté à un autre instant.

2. Procédé suivant la revendication 1, caractérisé en ce que les opérations consistant à exciter le circuit magnétique, et à détecter les changements d'état de ce dernier sont périodiquement réitérées pour effectuer une surveillance continue de l'absence de tout déplacement relatif des premier et second éléments.

## Claims

1. A method of detecting temporary displacement from an initial relative position of a first member (1) relative to a second (2), characterized in that it comprises the following steps:
- causing an initially magnetized remanent magnetic circuit (3a, 3b) to open in the event of the said first and second members being displaced from their initial relative position,
- exciting the magnetic circuit in such a way as to attempt to place it successively in a magnetized state, then in a demagnetized state, then in a magnetized state again,
- detecting the changes in state of the magnetic circuit at least at each attempted magnetization thereof, and
- producing a displacement detection signal in the event of a predetermined change of state of the magnetic circuit not being detected following the demagnetization of the circuit, or on the contrary being detected at another instant.

2. A method according to claim 1, characterized in that the steps consisting in exciting the magnetic circuit and in detecting the changes of state thereof are reiterated periodically in order to effect continuous surveillance for the absence of any relative displacement of the first and second members.

## Patentansprüche

1. Verfahren zur Erfassung der vorübergehenden Verstellung eines ersten Elements (1) in bezug auf ein zweites Element (2) aus einer relativen Anfangsstellung, dadurch gekennzeichnet, daß es die folgenden Schritte enthält:
- Veranlassung des Öffnens eines anfänglich magnetisierten Remanenz-Magnetkreises (3a, 3b) im Falle einer Verstellung des ersten und des zweiten Elements in bezug auf ihre relative Anfangsstellung,
- Erregung des Magnetkreises um zu versuchen, ihn nacheinander in einen magnetisierten Zustand, in einen entmagnetisierten Zustand und dann erneut in einen magnetisierten Zustand zu bringen,
- Erfassung der Zustandsänderungen des Magnetkreises wenigstens bei jedem Versuch von dessen Magnetisierung und
- Erzeugung eines Verstellungserfassungssignals in dem Fall, daß eine bestimmte Zustandsänderung des Magnetkreises im Anschluß an die Entmagnetisierung dieses Kreises nicht erfaßt worden ist oder außerdem in einem anderen Zeitpunkt erfaßt worden ist.

2. Verfahren nach Anspruch 1, dadurch gekennzeichnet, daß die Verfahrensschritte, die darin bestehen, den Magnetkreis zu erregen und dessen Zustandsänderungen zu erfassen, periodisch wiederholt werden, um eine kontinuierliche Überwachung des Fehlens jeglicher relativen Verstellung des ersten und des zweiten Elements durchzuführen.
